# EUROPÄISCHE PATENTSCHRIFT

(11) **EP 4 059 049 B1**
(45) Veröffentlichungstag und Bekanntmachung des Hinweises auf die Patenterteilung: **19.06.2024**
(21) Anmeldenummer: 20797059.1
(22) Anmeldetag: 19.10.2020
(51) Int. Cl.: H01L 23/373, H01L 23/367

(54) **METALL-KERAMIK-SUBSTRAT UND VERFAHREN ZUR HERSTELLUNG EINES SOLCHEN METALL-KERAMIK-SUBSTRATS**
METAL-CERAMIC SUBSTRATE AND METHOD FOR PRODUCING A METAL-CERAMIC SUBSTRATE OF THIS TYPE
SUBSTRAT MÉTAL-CÉRAMIQUE ET PROCÉDÉ DE PRODUCTION DE SUBSTRAT MÉTAL-CÉRAMIQUE DE CE TYPE

(30) Priorität: 19.12.2019 DE 102019135146
(43) Veröffentlichungstag der Anmeldung: 21.09.2022
(73) Patentinhaber: Rogers Germany GmbH, 92676 Eschenbach (DE)
(72) Erfinder: GIL, Vitalij, 91217 Hersbruck (DE); MATHIEU, Olivier, 92676 Eschenbach (DE); POLSTER, Sebastian, 92676 Eschenbach (DE)
(74) Vertreter: Müller, Frank Peter
(86) Internationale Anmeldenummer: PCT/EP2020/079346
(87) Internationale Veröffentlichungsnummer: WO 2021/121728

(56) Entgegenhaltungen:
- EP-A1- 0 560 259
- EP-A1- 3 392 907
- DE-A1-102012 102 611
- DE-A1-102016 125 348
- JP-A- 2003 324 173
- US-A1- 2014 367 702
- US-A1- 2015 130 042

## Beschreibung

Die vorliegende Erfindung betrifft ein Metall-Keramik-Substrat.

Trägersubstrate für elektrische Bauteile, beispielsweise in Form von Metall-Keramik-Substraten, sind beispielsweise als Leiterplatten oder Platinen aus dem Stand der Technik hinlänglich bekannt, beispielsweise aus der DE 10 2013 104 739 A1, der DE 19 927 046 B4, der DE 10 2009 033 029 A1, der EP3392907 A1, der DE 10 2016 125 348 A1 und der DE 10 2012 102 611 A1. Typischerweise werden auf einer Bauteilseite des Metall-Keramik-Substrats Anschlussflächen für elektrische Bauteile und Leiterbahnen angeordnet, wobei die elektrischen Bauteile und die Leiterbahnen zu elektrischen Schaltkreisen zusammenschaltbar sind. Wesentliche Bestandteile der Metall-Keramik-Substrate sind eine Isolationsschicht, die bevorzugt aus einer Keramik gefertigt ist, und eine an die Isolationsschicht angebundene Metallschicht bzw. Bauteilmetallisierung. Wegen ihren vergleichsweise hohen Isolationsfestigkeiten haben sich aus Keramik gefertigte Isolationsschichten in der Leistungselektronik als besonders vorteilhaft erwiesen. Durch eine Strukturierung der Metallschicht können sodann Leiterbahnen und/oder Anschlussflächen für die elektrischen Bauteile realisiert werden.

Für solche Trägersubstrate, insbesondere für Metall-Keramik-Substrate, besteht aufgrund der unterschiedlichen Materialwahl für die Isolationsschicht einerseits und Metallisierung andererseits das Problem unterschiedlicher thermischer Ausdehnungskoeffizienten, die bei einer Wärmeentwicklung, die beispielsweise im Betrieb oder bei der Fertigung des Trägersubstrats auftreten, thermomechanische Spannungen induzieren bzw. veranlassen, die zu einem Verbiegen oder gar zu einer Beschädigung des Trägersubstrats führen können. Daher hat es sich im Stand der Technik etabliert, an einer der Bauteilmetallisierungen gegenüberliegenden Seite der Isolationsschicht eine Rückseitenmetallisierung vorzusehen, um mit der entsprechenden Symmetrie im Hinblick auf die thermischen Ausdehnungskoeffizienten in Stapelrichtung einem Durchbiegen entgegenzuwirken. Da allerdings die Bauteilmetallisierung in der Regel nicht dicker wird als 0,8 mm, würde eine symmetrische Ausbildung der Rückseitenmetallisierung dazu führen, dass eine entsprechend ausgeformte Rückseitenmetallisierung sehr dünn ist und nicht die erforderliche Wärmekapazität bereitstellt, die insbesondere gewünscht ist, um einen Puffer in Überlastsituation bereitzustellen. Ungeachtet dessen wird im Stand der Technik auf eine Strukturierung der Rückseitenmetallisierung verzichtet, da dies einen Wärmstrompfad in einer parallel und senkrecht zur Haupterstreckungsebene verlaufenden Richtung auf Grunde des reduzierten Kupferanteils stört bzw. verschlechtert, der dann durch Luft oder ein Füllmittel ersetzt werden müsste. Darüber hinaus kann es zu elektrischen Problemen kommen, wenn ein Isolationsgraben auf der Rückseite des Trägersubstrats nicht verfüllt ist und sich bis zur Isolationsschicht erstreckt.

Weiterhin kennt der Stand der Technik Kühlstrukturen, beispielsweise finnenartige Kühlkörper, die typischerweise an die Rückseitenmetallisierung angebunden werden, um für den entsprechenden Wärmeabtransport im Betrieb oder während der Fertigung zu sorgen.

Ausgehend vom Stand der Technik macht es sich die vorliegende Erfindung zur Aufgabe, Trägersubstrate bereitzustellen, die gegenüber denen aus dem Stand der Technik bekannten Trägersubstraten verbessert sind, insbesondere in Hinblick auf ihre Effizienz beim Abtransport von Wärme bzw. Energie und in Hinblick auf ihre Maßnahmen, die einem thermomechanisch induzierten Durchbiegen entgegenwirken.

Diese Aufgabe wird durch ein Trägersubstrat für elektrische Bauteile gemäß Anspruch 1 gelöst. Weitere Vorteile und Eigenschaften ergeben sich aus den Unteransprüchen sowie der Beschreibung und den beigefügten Figuren.

Gegenüber den aus dem Stand der Technik bekannten Trägersubstraten ist es erfindungsgemäß vorgesehen, dass die erste Primärstrukturierung und die zweite Primärstrukturierung in Stapelrichtung gesehen zumindest abschnittsweise deckungsgleich verlaufen. Dadurch wird die Symmetriegestaltung zwischen Bauteilmetallisierung und Kühlteilmetallisierung signifikant erhöht, was mit Vorteil einem Durchbiegen des Trägersubstrats entgegenwirkt. Mit anderen Worten: die symmetrische Gestaltung zwischen Bauteilmetallisierung und Rückseitenmetallisierung ist nicht ausschließlich auf eine entsprechende Ausgestaltung der jeweiligen Dicken beschränkt, sondern wird vorzugsweise gezielt durch das Einstellen einer deckungsgleichen Anordnung der ersten und zweiten Primärstrukturierung veranlasst bzw. unterstützt. Dadurch wird in vorteilhafter Weise die Symmetrie zwischen Bauteilmetallisierung und Kühlteilmetallisierung erhöht, wodurch einem Durchbiegen wirkungsvoll entgegengewirkt werden kann.

Dabei sind unter Strukturierungen, insbesondere der ersten Primärstrukturierung und der zweiten Primärstrukturierung, Ausnehmungen bzw. Rücksprünge zu verstehen, die an der Außenseite der jeweiligen Metallisierung, d. h. der Kühlseitenmetallisierung oder Bauteilmetallisierung, ausgestaltet sind. Dabei erstrecken sich die entsprechenden Aussparungen, d. h. die erste Primärstrukturierung und/oder die zweite Primärstrukturierung, vorzugsweise entlang einer Erstreckungsrichtung, die im Wesentlichen parallel zur Haupterstreckungsebene verläuft. Weiterhin ist es vorgesehen, dass die Isolationsschicht, die Bauteilmetallisierung und die Kühlteilmetallisierung sich jeweils entlang einer Haupterstreckungsebene erstrecken und in Stapelrichtung, die senkrecht zur Haupterstreckungsebene verläuft, übereinander angeordnet sind. Insbesondere ist die Kühlteilmetallisierung unmittelbar, beispielsweise über ein DCB- oder ein AMB-Verfahren, an die Isolationsschicht, insbesondere an eine Kühlseite der Isolationsschicht angebunden. Die Kühlmetallisierung kann beispielsweise auch nachträglich ausgebildet werden. Beispielsweise wird hierzu eine Rückseitenmetallisierung, beispielsweise mittels DCB oder AMB Verfahren hergestellt und anschließend werden stegartige Pin-Elemente an die Rückseitenmetallisierung angebunden, um eine Finnenstruktur für die Bildung der Kühlteilmetallisierung auszubilden. Sofern von einem abschnittsweisen deckungsgleichen Verlauf gesprochen wird, ist insbesondere die zumindest teilweise deckungsgleiche Anordnung entlang der jeweiligen Erstreckungsrichtungen der ersten Primärstrukturierung und der zweiten Primärstrukturierung zu verstehen. Beispielswiese ist die Strukturierung der ersten Primärstrukturierung, der zweiten Primärstrukturierung, der ersten Sekundärstrukturierung und/oder der zweiten Sekundärstrukturierung durch Ätzen, Fräsen, Prägen, Strangpressen, Extrudieren, Kaltfließpressen oder durch eine Kombination dieser Verfahren hergestellt worden.

Unter einer deckungsgleichen Anordnung der Strukturierungen, d. h. der ersten und der zweiten Primärstrukturierung, ist vorzugsweise zu verstehen, dass in Stapelrichtung gesehen die Strukturierungen, d. h. die Aussparungen bzw. Rücksprünge in den Kühlseitenmetallisierung und der Bauteilmetallisierung, zumindest abschnittsweise überlappend angeordnet sind. Mit anderen Worten: In Stapelrichtung gesehen überlappen die Projektionen der ersten Primärstrukturierung und zweiten Primärstrukturierung. Es ist dabei vorstellbar, dass die erste Primärstrukturierung und die zweiter Primärstrukturierung im Wesentlichen gleich breit sind und die Strukturierungen in Stapelrichtung gesehen vollständig überlappen, d. h. die Begrenzung der ersten Primärstrukturierung und der zweiten Primärstrukturierung sind ebenfalls zueinander deckungsgleich angeordnet. Unter der deckungsgleichen Anordnung der ersten Primärstrukturierung und der zweiten Primärstrukturierung ist auch eine solche zu verstehen, bei der die erste und die zweite Primärstrukturierung in Stapelrichtung nur teilweise überlappend zueinander angeordnet sind. Beispielsweise ist es auch vorstellbar, dass die Mittelpunkte bzw. Zentren der ersten Primärstrukturierung und der zweiten Strukturierung in Stapelrichtung gesehen übereinander angeordnet sind oder zueinander versetzt sind. Vorzugsweise ist ein Abstand, um den die Mittelpunkte zueinander versetzt sind, geringer als eine Breite der schmaleren der beiden Strukturierungen (d. h. der ersten Primärstrukturierung oder der zweiten Primärstrukturierung), bevorzugt geringer als 50 % der Breite der schmaleren der beiden Strukturierungen und besonders bevorzugt geringer als 25 % der Breite der schmaleren der beiden Strukturierungen. Als Mittelpunkt ist die Mitte zwischen den lateralen Begrenzungen der Strukturierungen in der Kühlseitenmetallisierung bzw. der Bauteilmetallisierung zu verstehen.

Weiterhin ist es vorstellbar, dass der Anteil des in Stapelrichtung gesehen überlappenden Bereichs der ersten und der zweiten Primärstrukturierung zu einer Breite der ersten Primärstrukturierung oder der zweiten Primärstrukturierung, vorzugsweise der schmaleren oder der breiteren der beiden Strukturierungen (d. h. der ersten Primärstrukturierung und der zweiten Primärstrukturierung) größer ist als 50 %, bevorzugt größer als 75 % und besonders bevorzugt größer als 90 %.

Es ist ferner vorstellbar, dass zu einer zweiten Primärstrukturierung mehrere erste Primärstrukturierungen in Stapelrichtung gesehen deckungsgleich oder zu einer ersten Primärstrukturierung mehrere zweite Primärstrukturierungen in Stapelrichtung gesehen deckungsgleich angeordnet sind

Weiterhin ist es bevorzugt vorgesehen, dass die Isolationsschicht aus einer Keramikschicht, insbesondere einer einzelnen Keramikschicht, ausgeformt ist. Es ist auch vorstellbar, dass die Isolationsschicht mehrlagig ist und beispielsweise eine aus Keramik gebildete Primärschicht und eine Sekundärschicht aufweist, wobei zwischen der Primär- und der Sekundärschicht eine metallische Zwischenschicht angeordnet ist, wobei die metallische Zwischenschicht dicker ist in Stapelrichtung gemessen als die Primär- und/oder Sekundärschicht und/oder größer ist als 1 mm. Dabei kann bereits in der Isolationsschicht eine Wärmeaufspaltung unterstützt werden, die den Abtransport der Wärme fördert. Damit versteht der Fachmann unter einer Isolationsschicht im Sinne dieser Anmeldung auch einen Verbund, der selbst aus mehreren Schichten ausgebildet werden kann. Es ist auch vorstellbar, dass die Isolationsschicht eine Hybridkeramikschicht ist, bei der eine erste Schicht aus einem ersten keramischen Werkstoff und eine zweite Schicht aus einem zweiten keramischen Werkstoff entlang der Stapelrichtung übereinander angeordnet sind, um die Isolationsschicht auszubilden.

Weiterhin ist vorgesehen, dass die Bauteilmetallisierung und/oder die Kühlteilmetallisierung unmittelbar und direkt an die Isolationsschicht angebunden ist, beispielsweise angebunden mittels eines DCB-Verfahrens, eines AMB-Verfahrens oder mittels einer Dünnschichttechnik. Ferner umfasst das Metall-Keramik-Substrat mindestens eine Metallschicht bzw. Metallabschnitt, beispielsweise als Teil der Kühlseitenmetallisierung oder der Bauteilmetallisierung, die an einer Außenseite einer Keramikschicht stoffschlüssig angebunden ist, wobei sich die Metallschicht und die Keramikschicht entlang einer Haupterstreckungsebene erstrecken und entlang einer senkrecht zur Haupterstreckungsebene verlaufenden Stapelrichtung übereinander angeordnet sind. Als Materialien für die Metallisierung bzw. den Metallabschnitt sind Kupfer, Aluminium, Molybdän und/oder deren Legierungen, sowie Laminate wie CuW, CuMo, CuAl, AlCu und/oder CuCu vorstellbar, insbesondere eine Kupfer-Sandwichstruktur mit einer ersten Kupferschicht und einer zweiten Kupferschicht, wobei sich eine Korngröße in der ersten Kupferschicht von einer zweiten Kupferschicht unterscheidet. Weiterhin ist bevorzugt vorgesehen, dass die mindestens eine Metallisierung, insbesondere die Bauteilmetallisierung, oberflächenmodifiziert ist. Als Oberflächenmodifikation ist beispielsweise eine Versiegelung mit einem Edelmetall, insbesondere Silber und/oder Gold, oder ENIG ("*electroless nickel immersion gold*") oder ein Kantenverguss an der ersten bzw. zweiten Metallisierungsschicht zur Unterdrückung einer Rissbildung bzw. -weitung denkbar.

Vorzugsweise weist die Keramikschicht Al₂O₃, Si₃N₄, AlN, eine HPSX-Keramik (d. h. eine Keramik mit einer Al₂O₃- Matrix, die einen x-prozentigen Anteil an ZrO₂ umfasst, beispielsweise Al₂O₃ mit 9% ZrO₂ = HPS9 oder Al₂O₃ mit 25% ZrO₂ = HPS25), SiC, BeO, MgO, hochdichtes MgO (> 90% der theoretischen Dichte), TSZ (tetragonal stabilisiertes Zirkonoxid) oder ZTA als Material für die Keramik auf. Es ist dabei auch vorstellbar, dass die Isolationsschicht als Verbund- bzw. Hybridkeramik ausgebildet ist, bei der zur Kombination verschiedener gewünschter Eigenschaften mehrere Keramikschichten, die sich jeweils in Hinblick auf ihre materielle Zusammensetzung unterscheiden, übereinander angeordnet und zu einer Isolationsschicht zusammengefügt sind. Vorzugsweise wird eine möglichst wärmeleitfähige Keramik für einen möglichst geringen Wärmewiderstand verwendet.

Dabei wird vorzugsweise die Metallisierung an die Isolierschicht mittels eines AMB-Verfahrens und/oder eines DCB-Verfahrens stoffschlüssig angebunden.

Unter einem "DCB-Verfahren" (Direct-Copper-Bond-Technology) oder einem "DAB-Verfahren" (Direct-Aluminium-Bond-Technology) versteht der Fachmann ein solches Verfahren, das beispielsweise zum Verbinden von Metallschichten oder - blechen (z. B. Kupferblechen oder -folien oder Aluminiumblechen oder -folien) miteinander und/oder mit Keramik oder Keramikschichten dient, und zwar unter Verwendung von Metall- bzw. Kupferblechen oder Metall- bzw. Kupferfolien, die an ihren Oberflächenseiten eine Schicht oder einen Überzug (Aufschmelzschicht), aufweisen. Bei diesem beispielsweise in der US 3 744 120 A oder in der DE23 19 854 C2 beschriebenen Verfahren bildet diese Schicht oder dieser Überzug (Aufschmelzschicht) ein Eutektikum mit einer Schmelztemperatur unter der Schmelztemperatur des Metalls (z. B. Kupfers), so dass durch Auflegen der Folie auf die Keramik und durch Erhitzen sämtlicher Schichten diese miteinander verbunden werden können, und zwar durch Aufschmelzen des Metalls bzw. Kupfers im Wesentlichen nur im Bereich der Aufschmelzschicht bzw. Oxidschicht.

Insbesondere weist das DCB-Verfahren dann z. B. folgende Verfahrensschritte auf:
- Oxidieren einer Kupferfolie derart, dass sich eine gleichmäßige Kupferoxidschicht ergibt;
- Auflegen der Kupferfolie auf die Keramikschicht;
- Erhitzen des Verbundes auf eine Prozesstemperatur zwischen etwa 1025 bis 1083°C, z. B. auf ca. 1071 °C;
- Abkühlen auf Raumtemperatur.

Unter einem Aktivlot-Verfahren, z. B. zum Verbinden von Metallschichten oder Metallfolien, insbesondere auch von Kupferschichten oder Kupferfolien mit Keramikmaterial ist ein Verfahren zu verstehen, welches speziell auch zum Herstellen von Metall-Keramik-Substraten verwendet wird, wird bei einer Temperatur zwischen ca. 600-1000 °C eine Verbindung zwischen einer Metallfolie, beispielsweise Kupferfolie, und einem Keramiksubstrat, beispielsweise Aluminiumnitrid-Keramik, unter Verwendung eines Hartlots hergestellt, welches zusätzlich zu einer Hauptkomponente wie Kupfer, Silber und/oder Gold auch ein Aktivmetall enthält. Dieses Aktivmetall, welches beispielsweise wenigstens ein Element der Gruppe Hf, Ti, Zr, Nb, Ce ist, stellt durch chemische Reaktion eine Verbindung zwischen dem Lot und der Keramik her, während die Verbindung zwischen dem Lot und dem Metall eine metallische Hartlöt-Verbindung ist. Alternativ ist zur Anbindung auch ein Dickschichtverfahren vorstellbar.

Gemäß einer besonders bevorzugten Ausführungsform ist die zweite Primärstrukturierung Teil einer Kühlstruktur. Dadurch erhält die zweite Primärstrukturierung eine Doppelfunktionalität, nämlich dahingehend, dass sie einerseits die Symmetrie im Trägersubstrat erhöht und andererseits es zulässt, dass ein Kühlfluid, beispielsweise eine Kühlflüssigkeit oder ein Kühlgas, vergleichsweise nah an die Isolationsschicht geführt werden kann und zudem eine Kontaktfläche zwischen dem Kühlfluid und der Kühlteilmetallisierung erhöht wird. Dies wirkt sich positiv auf die Kühleffizienz der Kühlteilmetallisierung aus.

Gemäß der vorliegenden Erfindung ist es vorgesehen, dass die Kühlteilmetallisierung eine zweite Sekundärstrukturierung aufweist, die insbesondere Teil der Kühlstruktur ist, wobei die zweite Primärstrukturierung eine zweite Tiefe und eine zweite Breite und die zweite Sekundärstrukturierung eine weitere zweite Tiefe und eine weitere zweite Breite aufweist, wobei
- die zweite Tiefe größer oder kleiner ist als die weitere zweite Tiefe und/oder
- die zweite Breite größer oder kleiner ist als die weitere zweite Breite.
Insbesondere ist es vorgesehen, dass die zweite Sekundärstrukturierung in der Kühlteilmetallisierung eine Finnenstruktur bereitstellt, die im Betrieb vom Kühlfluid umschlossen wird. Besonders bevorzugt ist es vorgesehen, dass die zweite Primärstrukturierung und die zweite Sekundärstrukturierung eine gemeinsame Kühlstruktur bilden, der gemeinsam ein Kühlfluid zugeführt wird bzw. entlang der das Kühlfluid geführt wird. Alternativ ist es auch vorstellbar, dass der zweiten Primärstrukturierung und der zweiten Sekundärstrukturierung jeweils isoliert das Kühlfluid zugeführt wird. Durch die Ausbildung einer zweiten Tiefe, die größer ist als die weitere zweite Tiefe der zweiten Sekundärstrukturierung, ragt die zweite Primärstrukturierung tief in die Kühlteilmetallisierung hinein und führt somit das Kühlfluid sehr nah an die Isolationsschicht heran. Weiterhin ist es besonders bevorzugt vorgesehen, dass die zweite Sekundärstrukturierung, d. h. insbesondere die Finnenstruktur, die mittels der zweiten Sekundärstrukturierung ausgeformt wird, unterhalb eines Metallabschnitts der Bauteilmetallisierung in Stapelrichtung gesehen angeordnet ist, wobei der Metallabschnitt in der Bauteilmetallisierung durch die erste Primärstrukturierung festgelegt bzw. begrenzt wird. Sofern die jeweilige Strukturierung in Hinblick auf Tiefe und/oder Breite moduliert ist bzw. variiert, wird vorzugsweise als effektive Tiefe bzw. Breite deren Mittel in Erstreckungsrichtung bzw. entlang einer senkrecht zur Erstreckungsrichtung verlaufenden Richtung angenommen. Weiterhin ist es vorstellbar, dass die zweite Tiefe einen Wert annimmt, der kleiner ist als 10 mm, bevorzugt kleiner als 8 mm und besonders bevorzugt kleiner als 7,5 mm oder sogar einen Wert zwischen 1 und 5 mm. Bevorzugt ist es vorgesehen, dass die zweite Tiefe einen Wert annimmt zwischen 1 und 20 mm, bevorzugt zwischen 1,5 und 15 mm und besonders bevorzugt zwischen 3,5 und 10 mm.

Weiterhin ist es vorstellbar, dass die Bauteilmetallisierung neben einer ersten Primärstrukturierung eine erste Sekundärstrukturierung aufweist, mit der beispielsweise gezielt Anschlüsse und/oder Leiterbahnen an der Bauteilseite hergestellt werden. Entsprechend gelten hier die Verhältnisangaben bezüglich Tiefe und Breite für die erste Primärstrukturierung und erste Sekundärstrukturierung, wie sie für die zweite Primärstrukturierung und die zweite Sekundärstrukturierung beschrieben wurden. Entsprechend dienen die erste Primärstrukturierung und die erste Sekundärstrukturierung insbesondere dazu, in einem Elektronikmodul bzw. Trägersubstrat einzelne Modulabschnitte voneinander zu trennen.

Bevorzugt ist es vorgesehen, dass die erste Primärstrukturierung eine erste Breite aufweist und die zweite Breite größer ist als die erste Breite, insbesondere ein Verhältnis zwischen der ersten Breite zu der zweiten Breite einen Wert zwischen 0,6 und 1, bevorzugt zwischen 0,7 und 1 und besonders bevorzugt zwischen 0,8 und 1 annimmt. Durch eine entsprechende Ausgestaltung der zweiten Breiten, die größer ist als die erste Breite ist es möglich, das Kühlfluid sogar abschnittsweise in der zweiten Primärstrukturierung unmittelbar unter den Metallabschnitt zu befördern, der durch die erste Primärstrukturierung isoliert bzw. begrenzt ist. Dadurch kann die Kühleffizienz gesteigert werden. Alternativ ist es vorstellbar, dass die zweite Breite kleiner als die erste Breite ist. Vorzugsweise nimmt ein Verhältnis zwischen der zweiten Breite zu der ersten Breite einen Wert zwischen 0,6 und 1 an, bevorzugt zwischen 0,7 und 1 und besonders bevorzugt zwischen 0,8 und 1. Insbesondere für das Verhältnis zwischen 0,8 und 1 hat es sich herausgestellt, dass sowohl eine wirksame Wärmeabfuhr als auch ein wirksames Entgegenwirken gegen das Durchbiegen veranlasst bzw. bedingt werden kann. Vorzugsweise nimmt die erste Breite und/oder die zweite Breite einen Wert zwischen 1 und 10 mm, bevorzugt zwischen 1 und 8 mm und besonders bevorzugt zwischen 1 und 2 mm. Beispielsweise nimmt die erste Breite und/oder zweite Breite einen Wert von 1,4 mm an. Vorzugsweise nimmt einer weitere zweite Breite einen Wert an, der größer ist als 1 mm, bevorzugt größer als 1,2 und besonders bevorzugt größer als 1,5 mm.

Besonders bevorzugt ist es vorgesehen, dass die Bauteilmetallisierung eine in Stapelrichtung bemessene erste Dicke aufweist, wobei die erste Dicke mindestens 1 mm dick ist, bevorzugt größer als 1,3 mm und besonders bevorzugt zwischen 1,5 mm und 3 mm oder sogar zwischen 2 mm und 4 mm ist. Beispielsweise ist die erste Dicke 2 mm groß. Mit einer entsprechendvergleichsweise großen ersten Dicke kann bereits eine Wärmespreizung in der Bauteilmetallisierung erfolgen, die sich vorteilhaft auswirkt auf die gesamte Kühleffizienz des Trägersubstrats. Bei einer entsprechend vergleichsweise dicken ersten Dicke der Bauteilmetallisierung erweist sich die Ausgestaltung der deckungsgleichen ersten und zweiten Primärstrukturierung als besonders vorteilhaft, da Abweichungen von der Symmetrie bei den entsprechenden Dickenverhältnissen vergleichsweise schnell bzw. leicht zum Durchbiegen des Trägersubstrats führen könnten. Daher erweist sich die Kombination der deckungsgleichen Anordnung von erster und zweiter Primärstrukturierung einerseits und der vergleichsweise ersten großen Dicke andererseits als besonders vorteilhaft.

Vorzugsweise ist es vorgesehen, dass die Kühlteilmetallisierung eine zweite Dicke aufweist, wobei vorzugsweise ein Verhältnis zwischen der ersten Dicke zur zweiten Dicke einen Wert zwischen 0,2 und 0,9 annimmt, bevorzugt zwischen 0,5 und 0,8 und besonders bevorzugt zwischen 0,5 und 0,75 und/oder wobei die zweite Primärstrukturierung eine Restmetalldicke aufweist, wobei ein Verhältnis der Restmetalldicke zu der zweiten Dicke einen Wert zwischen 0,01 und 0,7, bevorzugt zwischen 0,05 und 0,4 und besonders bevorzugt zwischen 0,1 und 0,3 annimmt. Es ist auch vorstellbar, dass das Verhältnis der ersten Dicke zur zweiten Dicke einen Wert vom mindestens 1, bevorzugt zwischen 1 und 15, besonders bevorzugt zwischen 1 und 10 und besonders bevorzugt zwischen 1,5 und 7 annimmt.

Bevorzugt nimmt die Restmetalldicke einen Wert zwischen 0,1 und 1,5 mm, bevorzugt zwischen 0,2 und 0,7 und besonders bevorzugt zwischen 0,3 und 0,5 mm an. Dabei ist die Restmetalldicke bevorzugt genau so dick oder dünner als eine Differenz aus der zweiten Dicke und der weiteren zweiten Tiefe. Die Differenz zwischen der zweiten Dicke und der weiteren zweiten Tiefe bestimmt dabei einen sich durchgehend erstrechenden Abschnitt der Kühlstruktur im Bereich der zweiten Sekundärstrukturierungen und wird somit durch den Abstand zwischen der Isolierschicht und einem Abschluss der zweiten Sekundärstrukturierung festgelegt. Vorzugsweise ist die Differenz zwischen der zweiten Dicke und der weiteren zweiten Tiefe größer als 1 mm und/oder größer oder kleiner als die erste Dicke. Es ist auch vorstellbar, dass die Differenz zwischen der zweiten Dicke und der zweiten Tiefe in etwa der ersten Dicke entspricht. Bevorzugt nimmt die Differenz zwischen der zweiten Dicke und der weiteren zweiten Tiefe einen Wert zwischen 0,2 mm und 5 mm, bevorzugt zwischen 0,5 und 3,5 mm und besonders bevorzugt einen Wert zwischen 1,5 und 2,5 mm an.

Insbesondere ist es vorstellbar, durch die Ausbildung einer Restmetalldicke im Bereich der zweiten Primärstrukturierung in der Kühlteilmetallisierung die entsprechende Wärmekapazität auf der Kühlseite zu erhöhen. Gleichzeitig wird vermieden, dass im Bereich der deckungsgleich angeordneten ersten Primärstruktur und zweiten Primärstruktur die Trennung von Kühlseite und Bauteilseite ausschließlich durch die Isolationsschicht erfolgt. Dies stärkt das Trägersubstrat mit Vorteil im Bereich der deckungsgleich angeordneten Primärstrukturierungen, d. h. der ersten Primärstrukturierung und der zweiten Primärstrukturierung.

Weiterhin ist es vorstellbar, dass die Differenz aus der zweiten Tiefe und der weiteren zweiten Tiefe einen Wert zwischen 0,5 und 1,9 mm, bevorzugt zwischen 1,3 und 1,8 mm und besonders bevorzugt zwischen 1,5 und 1,7 annimmt. Die Different zwischen der zweiten Tiefe und der weiteren zweiten Tiefe beschreibt die Dicke des massiven, insbesondere zwischen zwei ersten Sekundärstrukturierungen durchgehend erstreckenden, Abschnitts der Kühlstruktur bzw. der Kühlseitenmetallisierung.

Vorzugsweise ist es vorgesehen, dass ein Verhältnis der ersten Dicke zu einer Summe aus der weiteren zweiten Tiefe und der Restdicke einen Wert von mindestens 0,75, bevorzugt mindestens 1 und besonders bevorzugt vom mindesten 2 annimmt. Weiterhin ist es bevorzugt vorgesehen, dass das Verhältnis der ersten Dicke zu einer Summe aus der weiteren zweiten Tiefe und der Restdicke einen Wert zwischen 0,75 und 10, bevorzugt zwischen 1 und 8 und besonders bevorzugt zwischen 1,5 und 5 annimmt.

Die weitere zweite Tiefe nimmt beispielsweise einen Wert zwischen 0,5 mm und 30 mm, bevorzugt zwischen 2 und 15mm oder besonders bevorzugt zwischen 3 mm und 10 mm oder sogar zwischen 1 und 5 mm an. Die weitere zweite Tiefe wird dabei bevorzugt durch die Länge der Finnen bzw. Pins festgelegt. Es ist auch vorstellbar, dass die weitere zweite Tiefe dicker als 10 mm ist.

Vorzugsweise ist es vorgesehen, dass die Kühlteilmetallisierung unmittelbar an die Isolationsschicht angebunden ist. Beispielsweise erfolgt die unmittelbare Anmeldung der Kühlteilmetallisierung mittels eines DCB- oder AMB-Verfahrens. In entsprechender Weise verzichtet man auf eine Rückseitenmetallisierung und bindet die Kühlteilmetallisierung mit ihrer zweiten Primärstrukturierung und ihrer zweiten Sekundärstrukturierung unmittelbar an die Isolationsschicht an.

Vorzugsweise ist es vorgesehen, dass ein Verhältnis eines ersten Anteils an in Stapelrichtung bemessenen deckungsungleichen Abschnitten zu in Stapelrichtung bemessenen deckungsgleichen Abschnitten zwischen der ersten Primärstrukturierung und der zweiten Primärstrukturierung kleiner als 0,6, bevorzugt kleiner als 0,4 und besonders bevorzugt kleiner als 0,2 ist. Durch einen entsprechend großen Anteil an deckungsgleichen Abschnitten wird in vorteilhafter Weise die symmetrische Ausgestaltung über das gesamte Trägersubstrat unterstützt, wodurch großflächig über das Trägersubstrat ein Durchbiegen vermieden werden kann.

Vorzugsweise weist die zweite Primärstrukturierung an ihrem der Isolationsschicht zugewandten Ende einen eckigen, beispielsweise rechteckigen oder dreieckigen, einen parabelförmigen, einen wellenförmigen oder runden Abschluss auf. Insbesondere ist es vorstellbar, dass die entsprechende Ausformung des Abschlusses gezielt in Abhängigkeit des geplanten Einsatzes des Trägersubstrats erfolgt. So lässt sich beispielsweise durch die Ausformung des Abschlusses Einfluss nehmen auf die Eigenschaften des Durchbiegens und/oder der Wärmeabfuhreffizienz.

Vorzugsweise ist es vorgesehen, dass die zweite Primärstrukturierung entlang ihrer Erstreckung in einer senkrecht zur Haupterstreckungsebene verlaufenden Richtung, d. h. entlang ihrer Erstreckungsrichtung, zumindest abschnittsweise variiert, insbesondere periodisch moduliert ist. Dadurch lassen sich weitere Maßnahmen treffen, um eine gezielte Anpassung der Wärmekapazitäten und/oder der Durchbiegung bzw. Reduktion der Durchbiegung zu veranlassen, die vorzugsweise abhängig vom geplanten Einsatz des Trägersubstrats erfolgt.

Die zweite Primärstrukturierung und/oder die zweite Sekundärstrukturierung kann vorzugsweise durch eine Bearbeitung einer Metallisierung bzw. eines Metallabschnitts erfolgen, beispielsweise vor oder nach Anbinden an die Isolationsschicht. Dabei ist es denkbar, dass die Strukturen mittels Ätzen, Fräsen, Prägen, Strangpressen, Kaltfließpressen und/oder Ähnlichem hergestellt wird.

Weitere Vorteile und Merkmale ergeben sich aus der nachfolgenden Beschreibung bevorzugter Ausführungsformen des erfindungsgemäßen Gegenstands mit Bezug auf die beigefügten Figuren. Einzelne Merkmale der einzelnen Ausführungsform können dabei im Rahmen der Erfindung miteinander kombiniert werden.

Es zeigt:
- **Fig.1:**: ein Trägersubstrat gemäß einer Ausführungsform nach dem Stand der Technik,
- **Fig. 2**: ein Trägersubstrat gemäß einer weiteren Ausführungsform nach dem Stand der Technik,
- **Fig. 3**: ein Trägersubstrat gemäß einer ersten Ausführungsform der vorliegenden Erfindung,
- **Fig. 4**: Trägersubstrate aus Figur 3 in Draufsichten auf die Bauteilseite und die Kühlseite,
- **Fig. 5a bis 5h**: weitere Trägersubstrate nach weiteren beispielhaften Ausführungsformen der vorliegenden Erfindung,
- **Fig. 6a bis 6d**: weitere Trägersubstrate nach weiteren beispielhaften Ausführungsformen der vorliegenden Erfindung,
- **Fig. 7**: ein Trägersubstrat gemäß einer zweiten beispielhaften Ausführungsform der vorliegende Erfindung und
- **Fig. 8**: ein Trägersubstrat gemäß einer dritten beispielhaften Ausführungsform der vorliegenden Erfindung

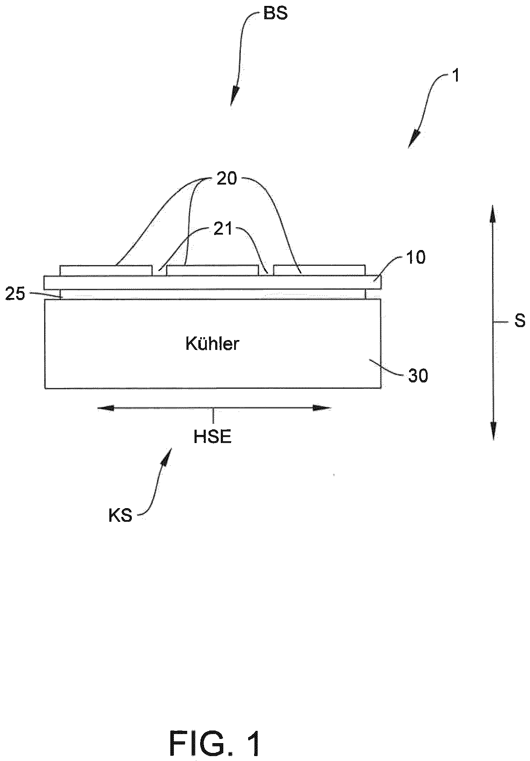

In **Figur 1** ist ein Trägersubstrat 1 gemäß einer Ausführungsform nach dem Stand der Technik gezeigt. Wesentliche Bestandteile eines solchen Trägersubstrats 1 für elektrische bzw. elektronische Bauteile ist eine Isolationsschicht 10, die sich im Wesentlichen entlang einer Haupterstreckungsebene HSE erstreckt und an dessen Bauteilseite BS eine Bauteilmetallisierung 20 angebunden ist. Eine entsprechende Strukturierung der Bauteilmetallisierung 20, insbesondere in Form einer ersten Primärstrukturierung 21, sorgt dafür, dass die Bauteilmetallisierung 20 einzelne, voneinander isolierte Metallabschnitte, insbesondere in Form von Metallflächen und/oder Leiterbahnen, aufweist. Hierzu erstrecken sich die Primärstrukturierungen 21 bis hin zur Isolationsschicht 10. Insbesondere wird unter einer ersten Primärstrukturierung 21 bzw. unter dem allgemeinen Begriff der Strukturierung, vom Fachmann die Ausbildung einer Ausnehmung bzw. Nut in der entsprechenden Metallisierung verstanden. Im Falle der ersten Primärstrukturierung 21 innerhalb der Bauteilmetallisierung 20 handelt es sich bei der ersten Primärstrukturierung 21 um einen Isolationsgraben, der die einzelnen Metallabschnitte, die durch die Primärstrukturierung 21 voneinander getrennt werden, voneinander isoliert. An den einzelnen Metallabschnitten der Bauteilmetallisierungsschicht 21 lassen sich sodann elektrische oder elektronische Bauteile anschließen.

Aufgrund der unterschiedlichen thermischen Ausdehnungskoeffizienten, die insbesondere der Isolationsschicht 10 und der Bauteilmetallisierung 20 zuzuschreiben sind, kann es bei einer Wärmeentwicklung, die beispielsweise im Rahmen eines Fertigungsprozesses und/oder im Betrieb des Trägersubstrats 1 auftritt, zu Verspannungen kommen, die zu einem Durchbiegen des Trägersubstrats 1 und ggf. sogar zu einer Schädigung oder Zerstörung des Trägersubstrats 1 führen können. Um dies zu verhindern, ist es aus dem Stand der Technik bekannt, eine Rückseitenmetallisierung 25 vorzunehmen, die einer entsprechenden Verbiegung entgegenwirkt. Bei typischerweise verwendeten ersten Dicken D1 für die Bauteilmetallisierung 20, von beispielsweise maximal 0,8 mm, hat es sich dabei insbesondere als vorteilhaft erwiesen, die Rückseitenmetallisierung 25 symmetrisch, insbesondere im Hinblick auf ihre Dicke, zu der Bauteilmetallisierung 20 auszugestalten. Über eine Kühlstruktur, die insbesondere wiederum an die Rückseitenmetallisierung 25 angebunden ist, beispielsweise durch ein AMB-Verfahren oder DCB-Verfahren, wird im Fertigungsprozess und/oder im Betrieb des Trägersubstrats 1 die sich entwickelnde Wärme schließlich von der Bauteilseite BS weggeführt. Ferner ist es vorgesehen, dass die Bauteilmetallisierung 20, die Isolationsschicht 10 und die Kühlteilmetallisierung 30 entlang einer Stapelrichtung S, die insbesondere senkrecht zur Haupterstreckungsebene HSE verläuft, übereinander angeordnet sind. Die für die Symmetrie erforderliche Rückseitenmetallisierung 25 erweist sich allerdings oftmals wegen ihrer geringen Dicke als nicht ausreichend in Hinblick auf ihre Wärmekapazität für thermische Impedanzen, insbesondere in Überlastfällen, in denen diese Rückseitenmetallisierung 25 als Pufferschicht dienen soll.

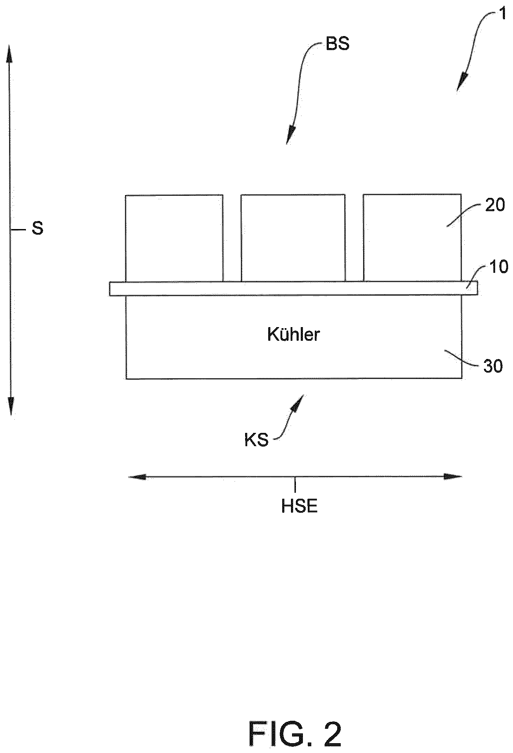

In **Figur 2** ist ein weiteres Trägersubstrat 1 gemäß einer weiteren Ausführungsform nach dem Stand der Technik dargestellt. Das in Figur 2 dargestellte Ausführungsbeispiel zeigt ein Trägersubstrat 1, bei dem die Bauteilmetallisierungen 20 und die Kühlteilmetallisierungen 30 an gegenüberliegenden Seiten der Isolationsschicht 10 unmittelbar bzw. direkt an die Isolationsschicht 10 angebunden sind. Dabei ist es insbesondere vorgesehen, dass die Bauteilmetallisierung 20 eine erste Dicke D1 von mindestens 1 mm aufweist, bevorzugt von mehr als 1,3 mm und besonders bevorzugt einen Wert zwischen 1,5 und 3 mm annimmt. Des Weiteren weist die Kühlteilmetallisierung 30 an einer der Bauteilseite BS gegenüberliegenden Kühlseite KS des Trägersubstrats 1 eine zweite Dicke D2 auf, die größer ist als die Rückseitenmetallisierung 25 aus dem Ausführungsbeispiel der Figur 1 und bevorzugt im Wesentlichen der ersten Dicke D1 entspricht. Zwar wird mit dieser vergleichsweise großen Kühlseitenmetallisierung 30 ein ausreichender Puffer und eine gewünschte Wärmekapazität bereitgestellt, allerdings sind bei einer derartigen Ausgestaltung von Bauteilmetallisierung 20 und Kühlteilmetallisierung 30 die Anforderungen an die Symmetrie zur Vermeidung einer Durchbiegung des gesamten Trägersubstrats 1 erhöht.

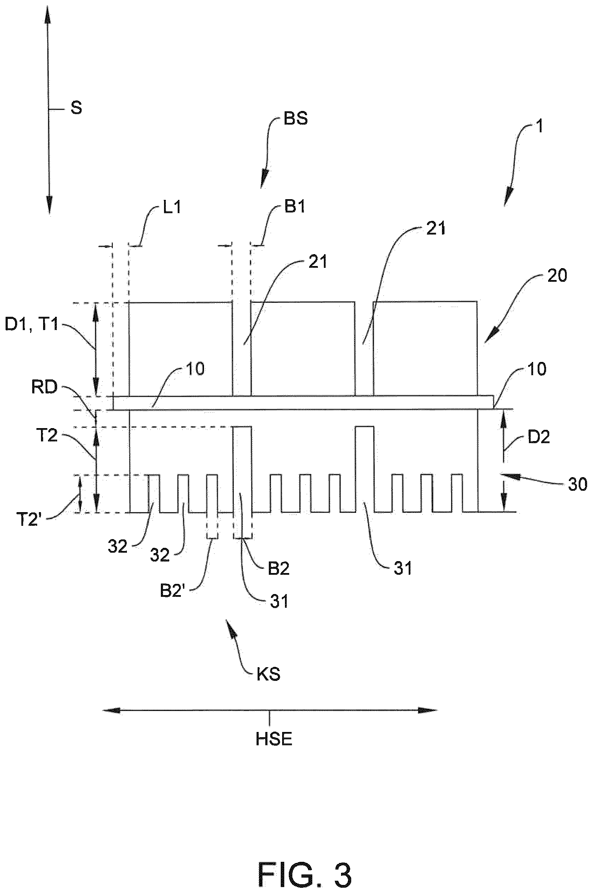

In **Figur 3** ist ein Trägersubstrat 1 gemäß einer ersten beispielhaften Ausführungsform der vorliegenden Erfindung dargestellt. In der dargestellten Ausführungsform weist das Trägersubstrat 1 neben einer ersten Primärstrukturierung 21 auf der Bauteilseite BS eine zweite Primärstrukturierung 31 an der Kühlseite KS des Trägersubstrats 1 auf. Dabei ist es insbesondere vorgesehen, dass die erste Primärstrukturierung 21 und die zweite Primärstrukturierung 31 in Stapelrichtung S gesehen zumindest abschnittsweise, beispielsweise entlang einer senkrecht zur Stapelrichtung S verlaufenden Richtung, deckungsgleich zueinander angeordnet sind. In der in Figur 3 dargestellten Ausführungsform ist es weiterhin vorgesehen, dass die Kühlteilmetallisierung 30 neben einer zweiten Primärstrukturierung 31 eine zweite Sekundärstrukturierung 32 aufweist. Die zweite Sekundärstrukturierung 32 formt insbesondere eine Finnenstruktur unterhalb eines Metallabschnittes ab, der von der ersten Primärstrukturierung 21 definiert wird bzw. zumindest abschnittsweise begrenzt wird. Dabei ist es insbesondere vorgesehen, dass die zweite Sekundärstrukturierung 32 eine weitere zweite Tiefe T2' und die zweite Primärstrukturierung 31 eine zweite Tiefe T2 aufweist, wobei die zweite Tiefe T2 größer als die weitere zweite Tiefe T2' ist. Mit anderen Worten: die zweite Primärstrukturierung 31 reicht tiefer in die Kühlteilmetallisierung 30 ein als die zweite Sekundärstrukturierung 32.

Weiterhin ist es vorgesehen, dass die zweite Primärstrukturierung 31 eine zweite Breite B2 aufweist und die zweite Sekundärstrukturierung 32 eine weitere zweite Breite B2', wobei insbesondere die zweite Breite B2 größer ist als die weitere zweite Breite B2'. Weiterhin ist es besonders bevorzugt vorgesehen, dass - im Gegensatz zur Bauteilmetallisierung 20 - in der Kühlteilmetallisierung 30 die zweite Primärstrukturierung 31 nicht bis zur Isolationsschicht 10 ragt bzw. reicht. Mit anderen Worten: im deckungsgleichen Bereich bzw. Abschnitt von erster Primärstrukturierung 21 und zweiter Primärstrukturierung 31 ist an dem der Isolationsschicht 10 zugewandten Ende der zweiten Primärstrukturierung 31 eine Restmetallisierung ausgebildet. Dadurch ist die zweite Tiefe T2 der Kühlteilmetallisierung kleiner als die zweite Dicke D2 der Kühlteilmetallisierung 30. Vorzugsweise entspricht die Differenz der zweiten Dicke D2 und der zweiten Tiefe T2 eine Restmetalldicke RD, wobei ein Verhältnis der Restmetalldicke RD zu der zweiten Dicke D2 einen Wert zwischen 0,01 und 0,7, bevorzugt zwischen 0,05 und 0,4 und besonders bevorzugt zwischen 0,1 und 0,3 annimmt.

Insbesondere lässt sich durch eine gezielte Einstellung der Restmetalldicke RD die Kühleffizienz der Kühlseite KS des Trägersubstrats 1 an die geplanten Anforderungen des Trägersubstrats 1 anpassen. Durch die deckungsgleiche Anordnung der ersten Primärstrukturierung 21 und der zweiten Primärstrukturierung 31 ist es weiterhin in vorteilhafter Weise möglich, die Symmetrie zwischen Bauteilseite BS und Kühlseite KS zu verbessern, um so einem entsprechenden Durchbiegen, insbesondere bei solchen Trägersubstraten 1 mit einer vergleichsweise großen ersten Dicke D1, d. h. einer ersten Dicke D1 größer als 1 mm, bevorzugt größer als 1,3 mm und besonders bevorzugt zwischen 1,5 und 3 mm, entgegenzuwirken.

Insbesondere ist es vorgesehen, dass bei der Bauteilmetallisierung 20 die erste Dicke D1 der ersten Tiefe T1 der ersten Primärstrukturierung 21 entspricht. Ferner ist es vorstellbar, dass auch die Bauteilmetallisierung 20 neben einer ersten Primärstrukturierung 21 auch eine erste Sekundärstrukturierung (nicht dargestellt) aufweist. Dabei gelten insbesondere die Verhältnisse zwischen Breite und Tiefe, wie für die zweite Primärstrukturierung 31 und die zweite Sekundärstrukturierung 32 beschrieben, analog für die erste Primärstrukturierung 21 und die erste Sekundärstrukturierung.

Insbesondere ist es vorgesehen, dass die zweite Primärstrukturierung 31 Teil der Kühlstruktur ist, die zur Kühlung des Trägersubstrats 1 verwendet wird. Insbesondere bildet dabei die zweite Primärstrukturierung 31 eine gemeinsame Kühlstruktur zusammen mit der zweiten Sekundärstrukturierung 32 aus. Dabei wird im Betrieb die Kühlstruktur, d. h. insbesondere die zweite Primärstrukturierung 31, dazu genutzt, ein Kühlfluid zu führen, um für einen entsprechenden Wärmeabtransport zu sorgen. Durch das Einbringen der zweiten Primärstrukturierung 31 in die Kühlteilmetallisierung 30, insbesondere mit einer zweiten Tiefe T2, die größer ist als die weitere zweite Tiefe T2`, ist es in vorteilhafter Weise möglich, sowohl die erforderliche Symmetrie zu realisieren, die einem Durchbiegen des Trägersubstrats 1 entgegenwirkt, als auch gleichzeitig dafür zu sorgen, dass die Kontaktfläche zwischen dem wärmeabtransportierendem Fluid und Kühlteilmetallisierung 20 vergrö-ßert wird. Dies wirkt sich positiv auf die Kühleffizienz des Trägersubstrats 1 aus.

Weiterhin ist ein sogenannter "Pullback", d. h. ein Überstand der Isolationsschicht 10 gegenüber dem äußersten Rand der Bauteilmetallisierung 20 bzw. der Kühlteilmetallisierung 30 in einer parallel zur Haupterstreckungsebene HSE verlaufenden Richtung vorgesehen. Dabei kann sich der Überstand auf der Bauteilseite BS von dem auf der Kühlteilseite KS unterscheiden. Vorzugsweise erstreckt sich der Überstand, insbesondere auf der Bauteilseite BS über eine erste Länge L1 von mehr als 0,5 mm. Damit werden elektrische Überschläge zwischen der Bauteilseite BS und der Kühlteilseite KS vermieden.

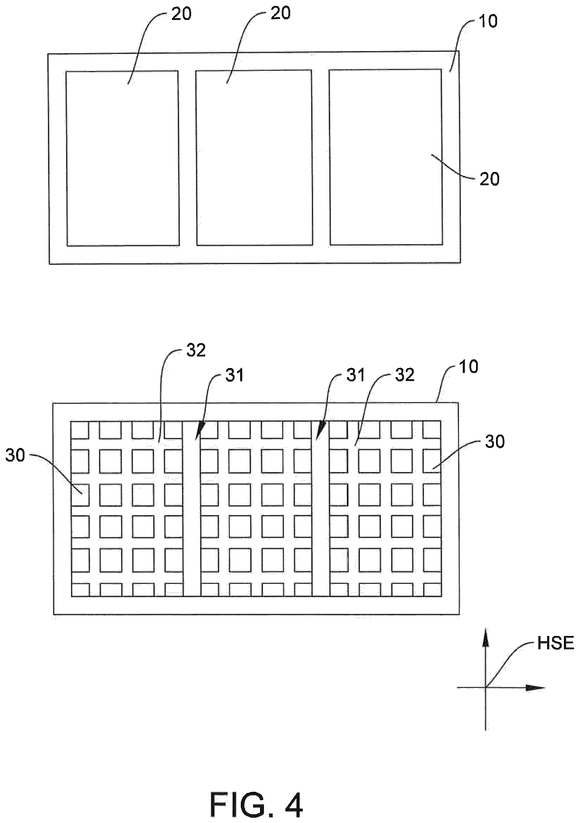

In **Figur 4** ist das Trägersubstrat 1 aus Figur 3 in einer Draufsicht auf die Bauteilseite BS (oben) und die Kühlseite KS (unten) dargestellt. Wie zu erkennen ist, wird die Bauteilmetallisierung 20 in rechteckige Metallabschnitte mittels der ersten Primärstrukturierung 21 unterteilt. Dabei sind die Metallabschnitte der Bauteilmetallisierung 20 großflächig und weisen keine erste Sekundärstrukturierung auf. Weiterhin ist es vorgesehen, dass in Stapelrichtung S gesehen, die Teilabschnitte mit der zweiten Sekundärstrukturierung 32 unterhalb der Metallabschnitte angeordnet sind, die durch die erste Primärstrukturierung 21 voneinander getrennt sind. Weiterhin ist zu erkennen, dass sich die zweite Primärstrukturierung 31 in einer senkrecht zur Stapelrichtung S verlaufenden Querrichtung über eine gesamte Breite der Kühlteilmetallisierung 30 erstreckt.

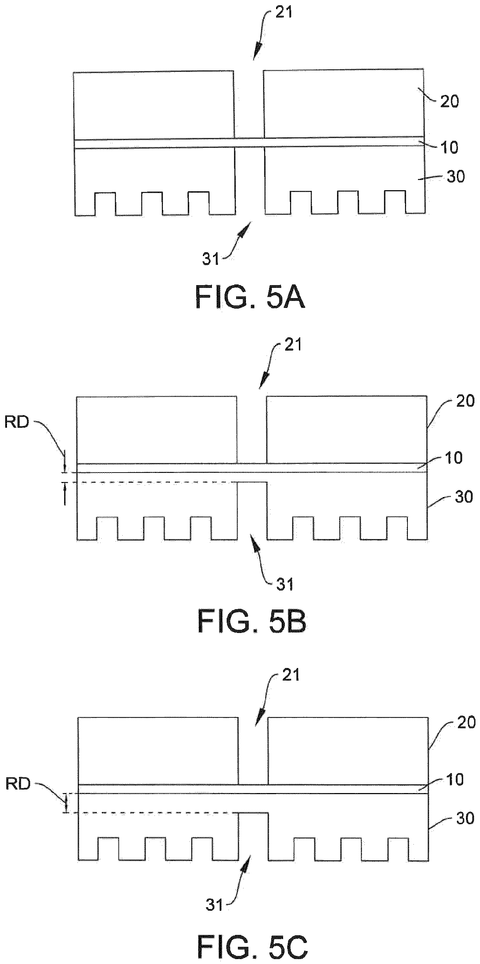

In den **Figuren 5A bis 5H** sind weitere Trägersubstrate 1 nach weiteren beispielhaften Ausführungsformen der vorliegenden Erfindung dargestellt. Beispielsweise zeigt die **Figur 5A** ein Trägersubstrat 1, bei dem sowohl die erste Primärstrukturierung 21 als auch die zweite Primärstrukturierung 31 jeweils bis zur Isolationsschicht 10 ragen bzw. reichen. Das heißt, in diesem Ausführungsbeispiel entspricht auch die zweite Tiefe T2 (der zweiten Primärstrukturierung 31) der zweiten Dicke D2 der Kühlteilmetallisierung 30.

In **Figur 5B** ist hingegen in den dargestellten Ausführungsformen eine Restmetalldicke RD bei der zweiten Primärstrukturierung 31 vorgesehen. Bei einer vollständigen Entfernung der Restmetalldicke RD, wie sie beispielsweise in Figur 5A dargestellt ist, wird insbesondere das Maß der Symmetrie verhältnismäßig groß. Mit einer Restmetalldicke RD für die zweite Primärstrukturierung 31 kann die entsprechende Restmetalldicke RD ebenfalls zur Kühleffizienz des Trägersubstrats 1 beitragen.

In **Figur 5C** ist die Restmetalldicke RD größer als in der Figur 5A. Dadurch wird die Kühleffizienz bzw. die Eigenschaften der Wärmekapazität für die Kühlteilmetallisierung 30 erhöht. Besonders bevorzugt ist es vorgesehen, dass in einem solchen Beispiel die zweite Dicke D2 reduziert wird und/oder die zweite weitere Tiefe T2`, um für eine entsprechende Kompensation in Hinblick auf den Symmetrieverlust zu sorgen.

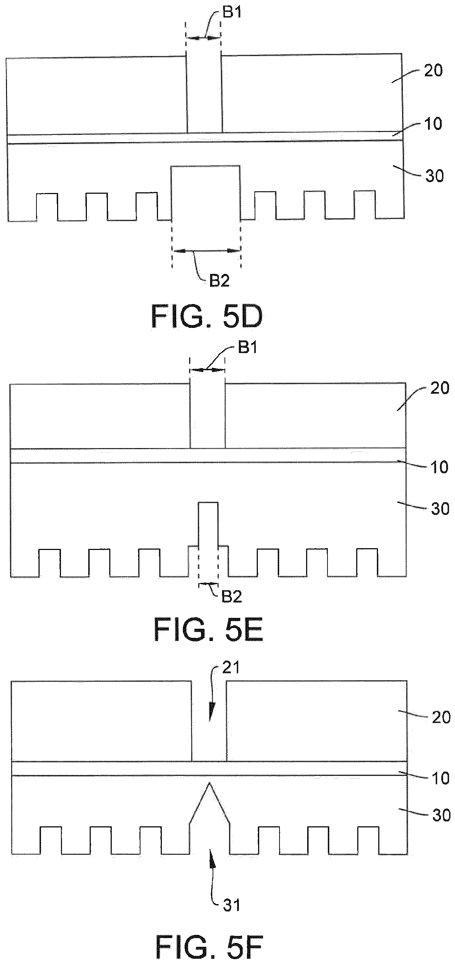

In dem Ausführungsbeispiel der **Figur 5D** ist eine zweite Breite B2 der zweiten Primärstrukturierung 31 größer als eine erste Breite B1 der ersten Primärstrukturierung 21, während in dem Ausführungsbeispiel der **Figur 5E** die zweite Breite B2 kleiner als die erste Breite B1 ist.

In **Figur 5F** ist eine zweite Primärstrukturierung 31 dargestellt, die insbesondere in Richtung der Isolationsschicht 10 gesehen verjüngt. Beispielsweise formt dabei das der Isolationsschicht 10 zugewandte Ende einen dreiecksförmigen bzw. spitz zulaufenden Abschluss aus. Insbesondere ist es dabei vorgesehen, dass ein Verjüngen in Stapelrichtung S gesehen nach bzw. mit der weiteren zweiten Tiefe T2`, d. h. in Stapelrichtung S gesehen hinter der Finnenstruktur, beginnt. Ferner ist es vorstellbar, dass der Abschluss geradlinige und/oder gebogene Abschnitte aufweist.

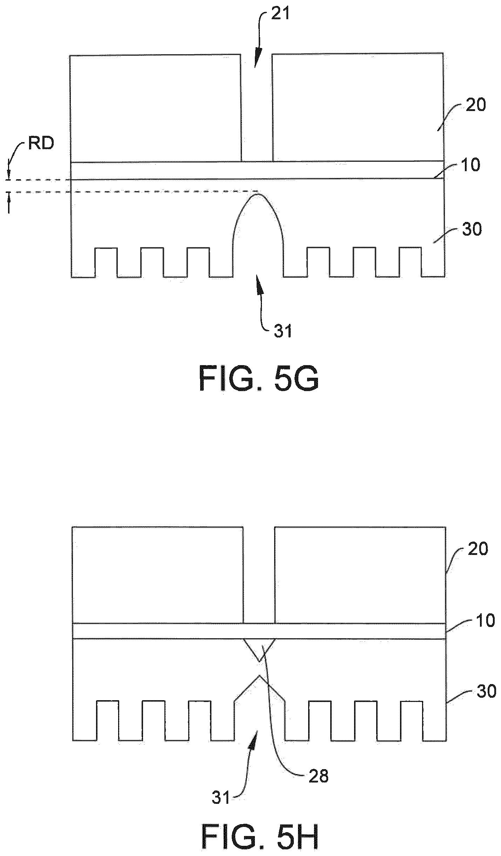

In der **Figur 5G** ist die zweite Primärstrukturierung 31 an ihrem der Isolationsschicht 10 zugewandten Ende parabelförmig und/oder rund ausgestaltet.

In der **Figur 5H** ist zusätzlich zu der zweiten Primärstrukturierung 31, die der Kühlseite KS zugewandt ist, ein Freiraum bzw. Freibereich 28 zwischen der Kühlteilmetallisierung 30 und der Isolationsschicht 10 vorgesehen. Insbesondere weist in der dargestellten Ausführungsform der Freibereich 28 in einem Querschnitt parallel zur Stapelrichtung S und insbesondere senkrecht zu einer Erstreckungsrichtung der zweiten Primärstrukturierung 31 einen dreieckigen Querschnitt auf. Ein derartiger Freibereich 28 lässt sich insbesondere vor dem Anbinden der Kühlteilmetallisierung 30 in die Kühlmetallisierung 30 einlassen, sodass nach dem Anbindungsprozess der Kühlteilmetallisierung 30 an die Isolationsschicht 10 ein entsprechender Freibereich 28 zwischen Kühlteilmetallisierung 30 und Isolationsschicht 10 ausgebildet ist. Dabei ist es vorgesehen, dass ein dem Freibereich 28 zugeordneter Querschnitt kleiner oder größer ist als ein der zweiten Primärstrukturierung 31 zugeordneter Querschnitt.

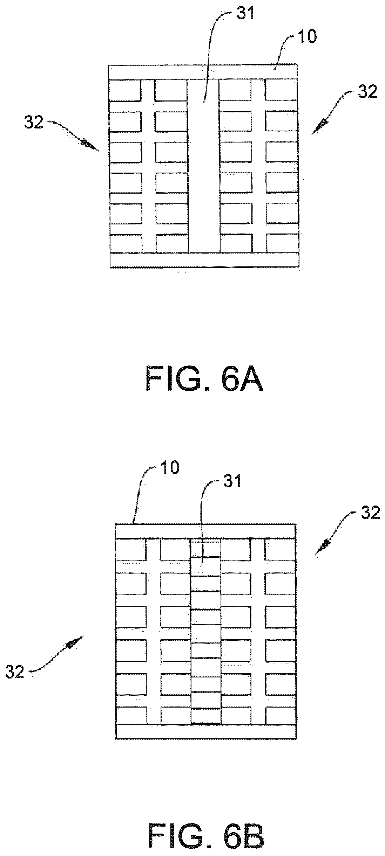

In den **Figuren 6A bis 6D** sind weitere Trägersubstrate 1 nach weiteren beispielhaften Ausführungsformen der vorliegenden Erfindung dargestellt. Insbesondere zeichnen sich die unterschiedlichen Ausführungsformen durch verschiedene Ausgestaltungen der zweiten Primärstrukturierung 31 entlang ihrer Erstreckungsrichtung senkrecht zur Stapelrichtung S aus. Beispielsweise zeigt die Bauteilseite BS bzw. die Draufsicht auf die Bauteilseite BS in der **Figur 6A****,** dass sich die zweite Primärstrukturierung 31 entlang ihrer Erstreckungslänge bzw. -richtung ohne Unterbrechungen und insbesondere ohne Modifikation ihrer zweiten Breite B2 (gemessen senkrecht zur generellen Erstreckungsrichtung) über die gesamte Breite (hier gemessenen entlang der Erstreckungslänge der ersten Primärstrukturierung 21) der Kühlteilmetallisierung 30 erstreckt bzw. Länge der Kühlteilmetallisierung 30 erstreckt.

In der in **Figur 6B** dargestellten Ausführungsform ist die zweite Primärstrukturierung 31 entlang ihrer Erstreckungslänge, insbesondere entlang einer senkrecht zur Stapelrichtung S verlaufenden Richtung unterbrochen. Dadurch bilden sich vergleichsweise kurze Bereich für die zweite Primärstrukturierung 31 aus, deren in senkrecht zur Erstreckungsrichtung bemessenen zweite Breite B2 größer ist als eine parallel zur Erstreckungsrichtung bemessene Länge. Dadurch wird der Anteil an Kühlteilmetallisierungen 20 erhöht, wodurch die Wärmekapazität der Kühlteilmetallisierung 20 erhöht wird.

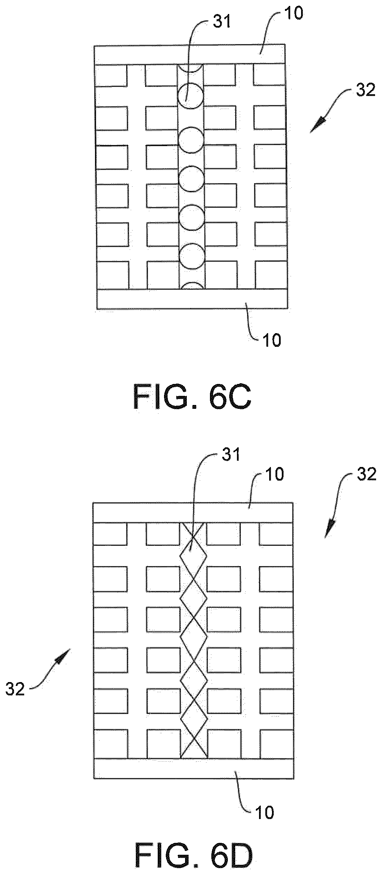

In den **Figuren 6C und 6D** sind die zweiten Primärstrukturierungen 31 periodisch moduliert und formen in einer parallel zur Haupterstreckungsebene HSE verlaufenden Ebene in **Figur 6C** kreisförmige oder elliptische Querschnitte bzw. rautenförmige Querschnitte **in** **Figur 6D** aus. Durch die unterschiedlichen geometrischen Gestaltungen der zweiten Primärstrukturierungen 31 lässt sich insbesondere vereinfacht eine Anpassung an die gewünschten Erfordernisse hinsichtlich Symmetrie und Wärmekapazität für den geplanten Einsatz des Trägersubstrats 1 anpassen.

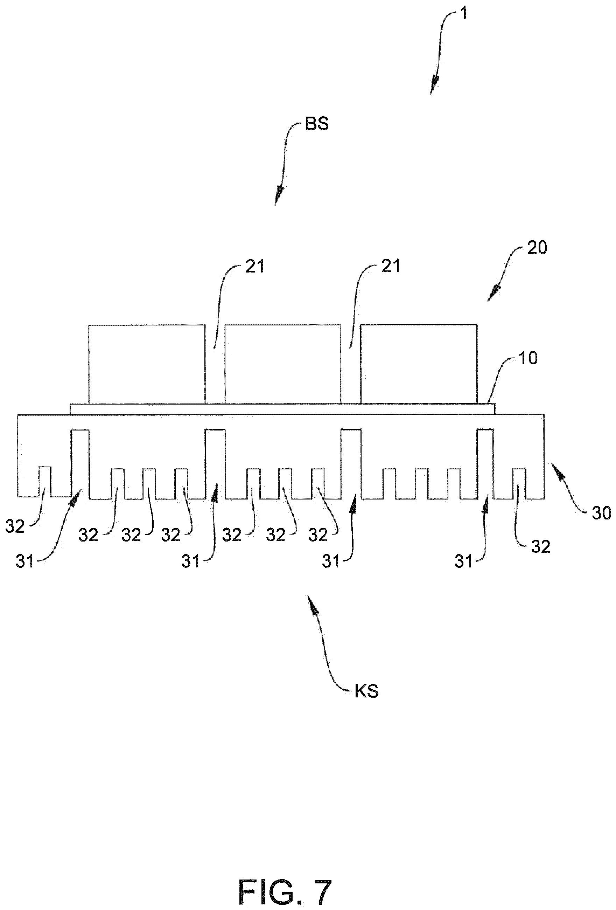

In **Figur 7** ist ein Trägersubstrat 1 gemäß einer zweiten beispielhaften Ausführungsform der vorliegenden Erfindung dargestellt. Dabei unterscheidet sich das in Figur 7 dargestellte Ausführungsbeispiel dadurch, dass in einer parallel zur Haupterstreckungsebene HSE verlaufenden Richtung die Rückseitenmetallisierung 25 oder Kühlteilmetallisierung 30 gegenüber der Isolationsschicht 10 übersteht. Dabei setzt die Rückseitenmetallisierung 25 oder die Kühlteilmetallisierung 30 vorzugsweise mit dem gegenüber der Isolationsschicht 10 vorstehenden bzw. überstehenden Abschnitt die Strukturierung, insbesondere die zweite Primärstrukturierung 31 und die zweite Primärstrukturierung 32, der Rückseitenmetallisierung 25 bzw. der Kühlteilmetallisierung 30 fort. Ein derartiger Überhang wirkt sich mit Vorteil auf die Wärmespreizung, insbesondere im Randbereich des Trägersubstrats 1, aus und kann vorzugsweise zur Abdichtung oder Aufnahme eines Dichtelements, beispielsweise eines Dichtrings, verwendet werden, mit dem eine Flüssigkeitsführung an die Rückseitenmetallisierung 25 bzw. Kühlteilmetallisierung 30 angebunden werden kann. Weiterhin ist es vorgesehen, dass in einer parallel zur Haupterstreckungsebene HSE verlaufenden Richtung ein Abschnitt mit einer überstehenden zweiten Sekundärstrukturierung 32 kürzer ist als eine nicht überstehende zweite Sekundärstrukturierung 32 zwischen zwei zweiten Primärstrukturierungen 31.

Vorzugsweise ist es dabei vorgesehen, dass eine der zweiten Primärstrukturierungen 31 in einer senkrecht zur Haupterstreckungsebene HSE verlaufenden Richtung deckungsgleich bzw. bündig abschließend zum äußersten Rand der Bauteilmetallisierung 20 ausgebildet ist. Dadurch ist es beispielsweise möglich, induzierte Spannungen im äußersten Randbereich der Bauteilmetallisierung 20 von der Rückseitenmetallisierung 25 oder der Kühlteilmetallisierung 30 bzw. dem Trägersubstrat 1 zu entkoppeln bzw. zu schwächen.

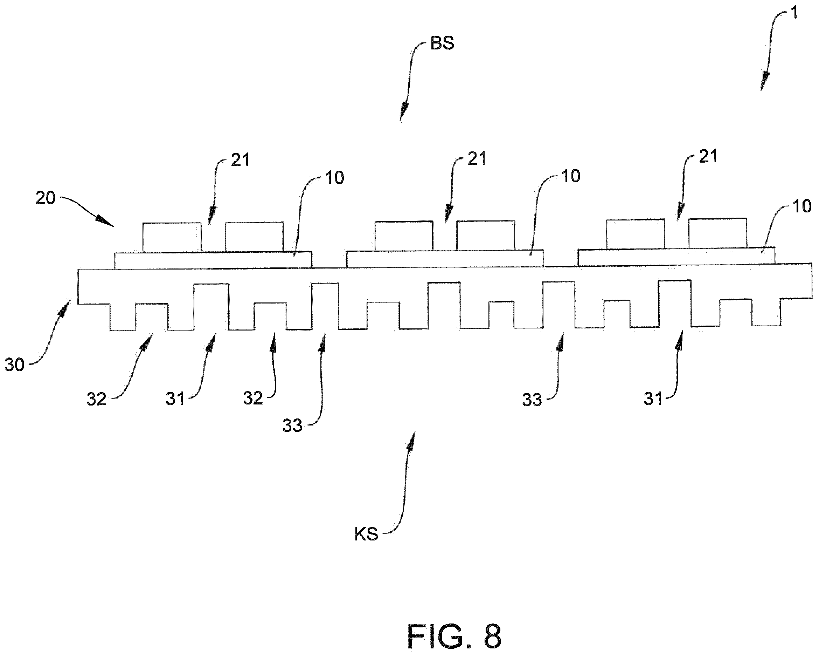

In **Figur 8** ist ein Trägersubstrat 1 gemäß einer dritten beispielhaften Ausführungsform der vorliegenden Erfindung dargestellt. Dabei unterscheidet sich die Ausführungsform der Figur 8 insbesondere dahingehend von denen aus der Figur 2 oder 7, dass die Isolationsschicht 10 mehrteilig ist, d. h. mehrere nebeneinander in einer parallel zur Haupterstreckungsebene HSE verlaufenden Ebene angeordnete Isolationsschichten 10 vorgesehen sind. Beispielsweise wird hierzu eine durchgehende Isolationsschicht 10 in mehrere separate Abschnitte unterteilt. Weiterhin ist es vorgesehen, dass unterhalb der Trennbereiche zwischen zwei benachbarten, insbesondere unmittelbar nebeneinander, separaten Isolationsschichten 10 deckungsgleich eine zweite Tertiärstrukturierung 33 vorgesehen ist. Dabei weist die zweite Tertiärstrukturierung 33 eine Tiefe auf, die der zweiten Tiefe T2 entspricht. Es ist auch vorstellbar, dass die Tiefe der zweiten Tertiärstrukturierung 33 größer oder kleiner ist als die zweite Tiefe T2 oder die weitere zweite Tiefe T2`. Gleiches gilt analog für die Breite, die der zweite Tertiärstrukturierung 33 zuzuordnen ist. Weiterhin ist es vorgesehen, dass die Breite der zweiten Tertiärstrukturierung 33 kleiner als ein Abstand zwischen zwei benachbarten Isolationsschichten 10 ist.

### Bezugszeichen:

- 1: Trägersubstrat
- 10: Isolationsschicht
- 20: Bauteilmetallisierung
- 21: erste Primärstrukturierung
- 25: Rückseitenmetallisierung
- 28: Freibereich
- 30: Kühlteilmetallisierung
- 31: zweite Primärstrukturierung
- 32: zweite Sekundärstrukturierung
- 33: zweite Tertiärstrukturierung
- KS: Kühlseite
- BS: Bauteilseite
- D1: erste Dicke
- D2: zweite Dicke
- RD: Restmetalldicke
- B1: erste Breite
- B2: zweite Breite
- B2': weitere zweite Breite
- T1: erste Tiefe
- T2: zweite Tiefe
- T2': weitere zweite Tiefe
- L1: erste Länge
- S: Stapelrichtung
- HSE: Haupterstreckungsebene

## Patentansprüche

1. Trägersubstrat (1) für elektrische Bauteile, umfassend
- eine Isolationsschicht (10), wobei die Isolationsschicht (10) vorzugsweise ein eine Keramik umfassendes Material oder einen mindestens eine Keramikschicht umfassenden Verbund aufweist,
- eine auf einer Bauteilseite (BS) ausgebildete Bauteilmetallisierung (20) mit einer ersten Primärstrukturierung (21) und
- eine an einer der Bauteilseite (BS) gegenüberliegenden Kühlseite (KS) ausgebildete Kühlteilmetallisierung (30) mit einer zweiten Primärstrukturierung (31),
wobei die Isolationsschicht (10), die Bauteilmetallisierung (20) und die Kühlteilmetallisierung (30) entlang einer Stapelrichtung (S) übereinander angeordnet sind und
wobei die erste Primärstrukturierung (21) und die zweite Primärstrukturierung (31) in Stapelrichtung (S) gesehen zumindest abschnittsweise deckungsgleich verlaufen, **dadurch gekennzeichnet, dass** die Kühlteilmetallisierung (30) eine zweite Sekundärstrukturierung (32), die insbesondere Teil der Kühlstruktur ist, aufweist, wobei die zweite Primärstrukturierung (31) eine zweite Tiefe (T2) und eine zweite Breite (B2) und die zweite Sekundärstrukturierung (32) eine weitere zweite Tiefe (T2') und eine weitere zweite Breite (B2`) aufweist, wobei die zweite Tiefe (T2) größer oder kleiner ist als die weitere zweite Tiefe (T2') und/oder die zweite Breite (B2) größer oder kleiner ist als die weitere zweite Breite (B2').

2. Trägersubstrat (1) gemäß Anspruch 1, wobei die zweite Primärstrukturierung (31) Teil einer Kühlstruktur ist.

3. Trägersubstrat (1) gemäß einem der vorhergehenden Ansprüche, wobei die Bauteilmetallisierung (20) eine in Stapelrichtung (S) bemessene erste Dicke (D1) aufweist, wobei die erste Dicke (D1) mindestens 1 mm, bevorzugt größer als 1,3 mm und besonders bevorzugt zwischen 1,5 mm und 3 mm ist.

4. Trägersubstrat (1) gemäß einem der vorhergehenden Ansprüche, wobei die Kühlteilmetallisierung (20) eine zweite Dicke (D2) aufweist, wobei ein Verhältnis zwischen der ersten Dicke (D1) zur zweiten Dicke (D2) einen Wert zwischen 0,2 und 0,9 annimmt, bevorzugt zwischen 0,5 und 0,8 und besonders bevorzugt zwischen 0,6 und 0,75.

5. Trägersubstrat (1) gemäß einem der vorhergehenden Ansprüche, wobei die zweite Primärstrukturierung (31) eine Restmetalldicke (RD) aufweist, wobei ein Verhältnis der Restmetalldicke (RD) zur der zweiten Dicke (D2) vorzugsweise einen Wert zwischen 0,01 und 0,7, bevorzugt zwischen 0,05 und 0,4 und besonders bevorzugt zwischen 0,1 und 0,3 annimmt.

6. Trägersubstrat (1) gemäß einem der vorhergehenden Ansprüche, wobei die Differenz zwischen der zweiten Dicke (D2) und der zweiten Tiefe (T2) in etwa der ersten Dicke (D1) entspricht

7. Trägersubstrat (1) gemäß einem der vorhergehenden Ansprüche, wobei die Kühlteilmetallisierung (30) unmittelbar an die Isolationsschicht (10) angebunden ist.

8. Trägersubstrat (1) gemäß einem der vorhergehenden Ansprüche, wobei ein Verhältnis eines ersten Anteils an in Stapelrichtung (S) bemessenen, deckungsungleichen Abschnitten zu in Stapelrichtung (S) bemessenen, deckungsgleichen Abschnitten zwischen der ersten Primärstrukturierung (21) und der zweiten Primärstrukturierung (31) kleiner als 0,6, bevorzugt kleiner als 0,4 und besonderes bevorzugt kleiner als 0,2 ist.

9. Trägersubstrat (1) gemäß einem der vorhergehenden Ansprüche, wobei die zweite Primärstrukturierung (31) an ihrem der Isolationsschicht (10) zugewandtem Ende einen eckigen, beispielsweise rechteckigen oder dreieckigen, einen parabelförmigen oder einen runden Abschluss aufweist.

10. Trägersubstrat (1) gemäß einem der vorhergehenden Ansprüche, wobei die zweite Primärstrukturierung (31) entlang ihrer Erstreckung in einer senkrecht zur Haupterstreckungsebene (HSE) verlaufenden Richtung zumindest abschnittsweise variiert, insbesondere periodisch moduliert ist.

11. Trägersubstrat (1) gemäß einem der vorhergehenden Ansprüche, wobei das Trägersubstrat ein Metall-Keramik-Substrat für elektrische Bauteile ist.

12. Trägersubstrat gemäß einem der vorhergehenden Ansprüche, wobei die Bauteilmetallisierung (20) neben einer ersten Primärstrukturierung (21) eine erste Sekundärstrukturierung aufweist, mit der beispielsweise gezielt Anschlüsse und/oder Leiterbahnen an der Bauteilseite hergestellt werden.

## Claims

1. A carrier substrate (1) for electrical components, comprising
- an insulating layer (10), wherein the insulating layer (10) preferably comprises a material that comprises a ceramic or a compound having at least one ceramic layer;
- a component metallization (20) formed on one component side (BS) with a first primary structure (21); and
- a cooling part metallization (30) formed on a cooling side (KS) opposite the component side (BS) and having a second primary structure (31),
wherein the insulating layer (10); the component metallization (20); and the cooling part metallization (30) are arranged on top of one another along a stacking direction (S) and
wherein the first primary structuring (21) and the second primary structuring (31), viewed in the stacking direction (S), extend congruently at least in sections, **characterized in that** the cooling part metallization (30) has a second secondary structure (32), which is in particular part of the cooling structure,
wherein the second primary structure (31) has a second depth (T2) and a second width (B2) and the second secondary structure (32) has a further second depth (T2') and a further second width (B2'), wherein the second depth (T2) is greater than or less than the further second depth (T2') and/or the second width (B2) is greater than or less than the further second width (B2').

2. The carrier substrate (1) according to claim 1, wherein the second primary structure (31) is part of a cooling structure.

3. The carrier substrate (1) according to one of the preceding claims, wherein the component metallization (20) has a first thickness (D1) dimensioned in the stacking direction (S), wherein the first thickness (D1) is at least 1 mm, preferably greater than 1.3 mm, and most preferably between 1.5 mm and 3 mm.

4. The carrier substrate (1) according to one of the preceding claims, wherein the cooling part metallization (20) has a second thickness (D2), wherein a ratio between the first thickness (D1) and the second thickness (D2) has a value between 0.2 and 0.9, preferably between 0.5 and 0.8 and most preferably between 0.6 and 0.75.

5. The carrier substrate (1) according to one of the preceding claims, wherein the second primary structure (31) has a remaining metal thickness (RD), wherein a ratio of the remaining metal thickness (RD) to the second thickness (D2) preferably has a value between 0.01 and 0.7, preferably between 0.05 and 0.4 and most preferably between 0.1 and 0.3.

6. The carrier substrate (1) according to one of the preceding claims, wherein the difference between the second thickness (D2) and the second depth (T2) corresponds approximately to the first thickness (D1).

7. The carrier substrate (1) according to one of the preceding claims, wherein the cooling part metallization (30) is directly bonded to the insulating layer (10).

8. The carrier substrate (1) according to one of the preceding claims, wherein a ratio of a first proportion of congruent sections dimensioned in the stacking direction (S) to congruent sections between the first primary structure (21) and the second primary structure (31) dimensioned in the stacking direction (S) is less than 0.6, preferably less than 0.4 and most preferably less than 0.2.

9. The carrier substrate (1) according to one of the preceding claims, wherein the second primary structure (31) has an angular, for example rectangular or triangular, a parabolic or a round termination part at its end facing the insulating layer (10).

10. The carrier substrate (1) according to one of the preceding claims, wherein the second primary structure (31) is varied, in particular periodically modulated, at least in sections along its extension in a direction perpendicular to the main extension plane (HSE).

11. The carrier substrate (1) according to any one of the preceding claims, wherein the carrier substrate is a metal-ceramic substrate for electrical components.

12. Carrier substrate according to one of the preceding claims, wherein the component metallization (20) has, in addition to a first primary structure (21), a first secondary structure, with which, for example, connections and/or conductor paths are specifically created on the component side.

## Revendications

1. Substrat de support (1) pour composants électriques, comprenant
- une couche d'isolation (10), la couche d'isolation (10) contenant de préférence un matériau qui comprend une céramique ou un composite qui comprend au moins une couche de céramique,
- une métallisation de composant (20) formée sur un côté composant (BS) et présentant une première structuration primaire (21), et
- une métallisation de partie de refroidissement (30) formée sur un côté refroidissement (KS) opposé au côté composant (BS) et présentant une deuxième structuration primaire (31),
la couche d'isolation (10), la métallisation de composant (20) et la métallisation de partie de refroidissement (30) étant disposées les unes au-dessus des autres le long d'une direction d'empilement (S), et
la première structuration primaire (21) et la deuxième structuration primaire (31) s'étendant, vues dans la direction d'empilement (S), au moins localement de manière à coïncider,
**caractérisé en ce que** la métallisation de partie de refroidissement (30) présente une deuxième structuration secondaire (32) qui fait partie en particulier de la structure de refroidissement, la deuxième structuration primaire (31) présentant une deuxième profondeur (T2) et une deuxième largeur (B2), et la deuxième structuration secondaire (32) présentant une autre deuxième profondeur (T2') et une autre deuxième largeur (B2'), la deuxième profondeur (T2) étant supérieure ou inférieure à l'autre deuxième profondeur (T2'), et/ou la deuxième largeur (B2) étant supérieure ou inférieure à l'autre deuxième largeur (B2').

2. Substrat de support (1) selon la revendication 1,
dans lequel la deuxième structuration primaire (31) fait partie d'une structure de refroidissement.

3. Substrat de support (1) selon l'une des revendications précédentes,
dans lequel la métallisation de composant (20) présente une première épaisseur (D1) mesurée dans la direction d'empilement (S), la première épaisseur (D1) étant d'au moins 1 mm, de préférence supérieure à 1,3 mm et de manière particulièrement préférée comprise entre 1,5 mm et 3 mm.

4. Substrat de support (1) selon l'une des revendications précédentes,
dans lequel la métallisation de partie de refroidissement (20) présente une deuxième épaisseur (D2), un rapport entre la première épaisseur (D1) et la deuxième épaisseur (D2) prenant une valeur comprise entre 0,2 et 0,9, de préférence entre 0,5 et 0,8 et de manière particulièrement préférée entre 0,6 et 0,75.

5. Substrat de support (1) selon l'une des revendications précédentes,
dans lequel la deuxième structuration primaire (31) présente une épaisseur de métal résiduel (RD), un rapport de l'épaisseur de métal résiduel (RD) sur la deuxième épaisseur (D2) prenant de préférence une valeur comprise entre 0,01 et 0,7, de préférence entre 0,05 et 0,4 et de manière particulièrement préférée entre 0,1 et 0,3.

6. Substrat de support (1) selon l'une des revendications précédentes,
dans lequel la différence entre la deuxième épaisseur (D2) et la deuxième profondeur (T2) correspond approximativement à la première épaisseur (D1).

7. Substrat de support (1) selon l'une des revendications précédentes,
dans lequel la métallisation de partie de refroidissement (30) est directement liée à la couche d'isolation (10).

8. Substrat de support (1) selon l'une des revendications précédentes,
dans lequel un rapport d'une première proportion de parties non coïncidentes, mesurées dans la direction d'empilement (S), sur des parties coïncidentes, mesurées dans la direction d'empilement (S), entre la première structuration primaire (21) et la deuxième structuration primaire (31) est inférieur à 0,6, de préférence inférieur à 0,4 et de manière particulièrement préférée inférieur à 0,2.

9. Substrat de support (1) selon l'une des revendications précédentes,
dans lequel la deuxième structuration primaire (31) présente, à son extrémité tournée vers la couche isolante (10), une terminaison polygonale, par exemple rectangulaire ou triangulaire, parabolique ou circulaire.

10. Substrat de support (1) selon l'une des revendications précédentes,
dans lequel la deuxième structuration primaire (31) est variée au moins localement, en particulier est modulée périodiquement, le long de son extension dans une direction perpendiculaire au plan d'extension principale (HSE).

11. Substrat de support (1) selon l'une des revendications précédentes,
dans lequel le substrat de support est un substrat métal-céramique pour composants électriques.

12. Substrat de support selon l'une des revendications précédentes,
dans lequel la métallisation de composant (20) présente, outre une première structuration primaire (21), une première structuration secondaire permettant par exemple de réaliser de façon ciblée des connexions et/ou des pistes conductrices sur le côté composant.
